Europäisches Patentamt

European Patent Office

Office européen des brevets

(11) Numéro de publication : **0 277 854 B1**

# (12) FASCICULE DE BREVET EUROPEEN

(45) Date de publication du fascicule du brevet :
**01.04.92 Bulletin 92/14**

(51) Int. Cl.$^5$ : **G06K 19/06, H01L 21/56**

(21) Numéro de dépôt : **88400068.8**

(22) Date de dépôt : **14.01.88**

---

(54) **Procédé de réalisation de cartes à mémoire et cartes obtenues par la mise en oeuvre dudit procédé.**

---

(30) Priorité : **16.01.87 FR 8700446**

(43) Date de publication de la demande :
**10.08.88 Bulletin 88/32**

(45) Mention de la délivrance du brevet :
**01.04.92 Bulletin 92/14**

(84) Etats contractants désignés :
**AT BE CH DE ES FR GB GR IT LI LU NL SE**

(56) Documents cités :
**FR-A- 2 520 541
GB-A- 2 081 974
PATENT ABSTRACTS OF JAPAN, vol. 9, no.
230 (E-343)[1953], 17 septembre 1985; & JP-
A-60 86 850 (DAINIPPON INSATSU K.K.) 16-
05-1985**

(56) Documents cités :
**PATENT ABSTRACTS OF JAPAN, vol. 9, no.
320 (P-413)[2043], 14 décembre 1985; & JP-
A-60 146 383 (DAINIPPON INSATSU K.K.) 02-
08-1985**

(73) Titulaire : **SCHLUMBERGER INDUSTRIES
50, avenue Jean Jaurès
F-92120 Montrouge (FR)**

(72) Inventeur : **Brignet, Marc
15, Avenue Laumière
F-75019 Paris (FR)**
Inventeur : **Droche, Emile
10, rue Alsace Lorraine
F-92250 La Garenne Colombes (FR)**

(74) Mandataire : **Dronne, Guy et al
Cabinet BEAU de LOMENIE, 55, rue
d'Amsterdam
F-75008 Paris (FR)**

EP 0 277 854 B1

## Description

La présente invention concerne un procédé de réalisation de cartes à mémoire notamment électronique et des cartes obtenues par la mise en oeuvre dudit procédé.

Les cartes à mémoire comprennent essentiellement un corps de carte qui est réalisé en général en un matériau plastique et un module mémoire.Dans le cas des cartes à mémoire électronique le module mémoire est un module électronique comportant essentiellement une pastille semi-conductrice ou "chip" dans laquelle est réalisé un circuit intégré et un élément de circuit imprimé sur lequel est fixé le chip et qui définit des plages externes de contact électrique. Le module électronique est fixé dans le corps de la carte de telle manière que les plages de contact électrique affleurent une des faces principales du corps de carte.

Le corps de carte a la forme d'un parallélèpipède rectangle dont l'épaisseur est réduite comparée aux autres dimensions du corps de carte. Les bords du corps de carte servent de référence pour le positionnement de la carte dans le lecteur de cartes de telle manière que les plages de contact de la carte viennent en contact électrique avec le connecteur du lecteur de cartes.

Deux techniques principales sont utilisées actuellement pour réaliser le corps de carte et l'implantation du module électronique dans le corps de carte. Selon une première technique, le corps de carte est réalisé par laminage à chaud de plusieurs feuilles de matériau plastique tel que de PVC. Le module électronique est mis en place dans l'empilement de feuilles de matériau plastique avant le laminage. Après l'opération de laminage, le module électronique est solidement ancré dans le corps de la carte. Ce procédé présente l'avantage de réaliser en une seule étape le corps de carte et l'implantation du module électronique dans le corps de carte. En revanche ce procédé est délicat et il nécessite le réusinage de la périphérie du corps de carte.

La deuxième technique consiste à réaliser le corps de carte dans une première étape, à usiner une cavité dans le corps de carte pour recevoir le module électronique et à coller le module électronique dans la cavité. L'usinage d'un tel corps de carte est toujours une opération délicate, donc onéreuse, car des cotes très précises doivent être respectées notamment pour assurer un positionnement correct du module électronique par rapport aux bords de la carte et par rapport à la face principale du corps de carte dans laquelle doivent affleurer les plages de contact électrique. De plus la fixation du module électronique dans le corps de carte ajoute des étapes supplémentaires, par exemple le collage.

Il faut ajouter que le corps de carte doit en outre répondre à d'autres spécifications concernant la qualité de l'état de surface et les propriétés de tenue en flextion bien précises ausi bien selon la direction longitudinale du corps de carte que selon sa direction transversale. De plus il faut que le corps de carte ne favorise pas le stockage de charges électrostatiques. Un objet de la présente invention est de fournir un procédé de réalisation de cartes à mémoire notamment à mémoire électronique qui permettre d'abaisser le coût de fabrication du corps de carte et qui réalise simultanément l'opération de fixation du module électronique dans le corps de carte, tout en répondant aux spécifications énoncées ci-dessus.

Le document EP-A-0 246 973, publié le 25 novembre 1987, décrit un procédé de réalisation de carte à élément électronique qui vise à obtenir une carte présentant un corps renforcé par un socle métallique. Les documents JP-A-60/146383 et JP-A-60/86850 décrivent des procédés de réalisation de cartes à mémoire électronique par moulage à l'aide d'une résine durcissable par un faisceau d'électrons ou par un rayonnement lumineux.

Pour atteindre ce but, selon l'invention, le procédé de réalisation d'une carte à mémoire électronique comprenant un module mémoire électronique comportant des plages de contact externes, une pastille semi-conductrice solidaire de la face postérieure desdits contacts, des moyens d'interconnexion des bornes de ladite pastille aux plages de contact et un matériau d'enrobage de ladite pastille et un corps de carte, caractérisé en ce qu'il comprend les étapes suivantes :

on fournit un module mémoire électronique comportant en outre une partie d'accrochage destinée à la fixation dudit module dans le corps de la carte par un engagement positif de forme et/ou par accrochage physico-chimique;

on place ledit module mémoire électronique dans un moule d'injection dont la cavité interne définit la forme du corps de carte et on maintient le module électronique de telle manière que les plages de contact externe soient plaquées contre une paroi de ladite cavité à l'aide de moyens solidaires dudit moule ;

on injecte à chaud et sous pression dans la cavité dudit moule un matériau thermo-plastique choisi dans le groupe comprenant l'acrylonitryl-butadiène-styrène, le polystyrène, le propylène et le polyamine 11, de telle manière que ledit matériau plastique remplisse la totalité de la cavité non occupée par ledit module, et

on démoule la pièce ainsi réalisée.

On comprend que, selon l'invention, le corps de la carte est directement réalisé par surmoulage du module mémoire. En une seule étape, on fabrique le corps de carte et on réalise l'implantation du module dans le corps. De plus le module pouvant être positionné dans le moule avec une grande précision, le module est également positionné avec une grande précision dans le corps de carte.

L'invention sera mieux comprise à la lecture de la description qui suit de plusieurs modes de mise en oeuvre de l'invention donnés à titre d'exemples non limitatifs. La description se réfère au dessins annexé sur lequel :

– La figure 1 est une vue de dessus d'une carte à mémoire électronique conforme à l'invention ;

– La figure 2 est une vue en coupe verticale d'un module électronique utilisable dans l'invention ;

– La figure 3 est une vue simplifiée en coupe d'un premier type de moule pour la mise en oeuvre de l'invention ;

– La figure 3a est une vue en coupe selon la ligne A-A de la figure 3, montrant une première variante du moule de la figure 3;

– La figure 3b est une vue en coupe selon la ligne A-A de la figure 3, montrant une deuxième variante du moule de la figure 3;

– La figure 4 est une vue simplifiée en coupe d'un deuxième type de moule pour la mise en oeuvre de l'invention ;

– La figure 5 est une vue partielle en coupe verticale d'une carte à mémoire électronique conforme à l'invention.

– La figure 6 est une vue de dessus d'un troisième type de moule permettant de réaliser simultanément plusieurs cartes ; et

– La figure 7 est une vue en coupe verticale selon la ligne VII-VII de la figure 6.

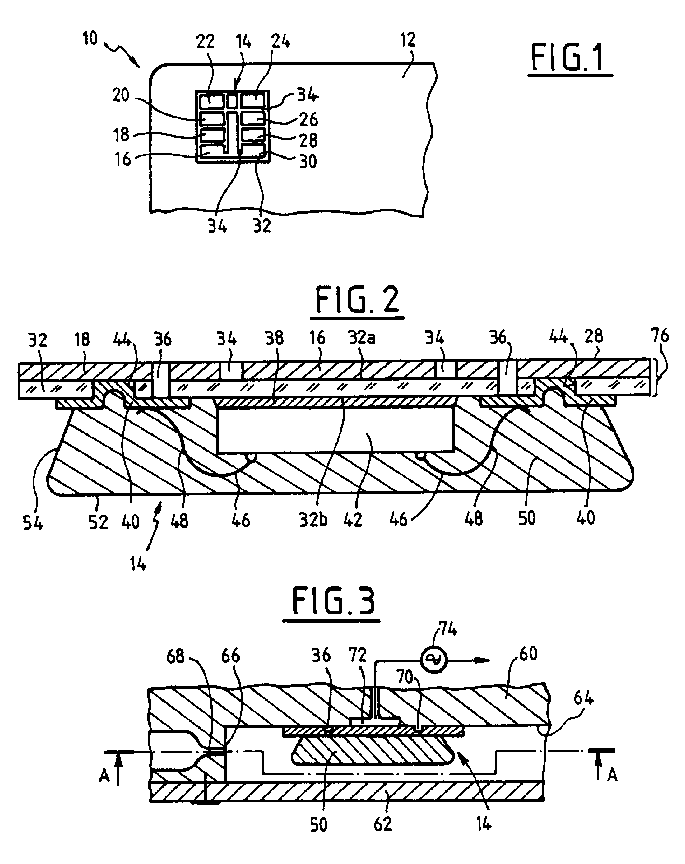

La figure 1 montre en vue de dessus une partie d'une carte à mémoire électronique 10. La carte 10 comporte un corps 12 réalisé en un matériau plastique et un module électronique 14 dont la figure 1 ne montre que des plages externes de contact électrique 16 à 30 disposées sur un support isolant 32. Comme cela est bien connu les plages de contact 16 à 30 sont destinées à entrer en contact électrique avec le connecteur des lecteurs de cartes utilisés pour fonctionner avec les cartes.

La figure 2 montre un module électronique 14 bien adapté pour la mise en oeuvre de l'invention. Le module 14 comprend un support isolant 32 sur la face 32a duquel sont réalisées les plages externes de contact électrique. La figure 2 montre les plages 18, 28 et 16. Les plages de contact sont séparées les unes des autres par des zones gravées telles que 34. Les plages de contact et le support isolant 32 comportent de plus une série de trous tels que 36 dont la fonction sera explicitée ultérieurement. La deuxième face 32b du support isolant 32 comporte également des métallisations 38, 40.

Une pastille semi-conductrice 42 est fixée sur la métallisation centrale 38 à l'aide d'un matériau adhésif conducteur. La métallisation 38 et les métallisations 40 sont électriquement reliées aux plages de contact 16 à 30 à travers des trous 44 ménagés dans le support isolant 32. En outre chaque borne 46 de la pastille semi-conductrice 42 est reliée à une métallisation 40 par un fil conducteur 48.

La pastille 42 et les fils 48 sont noyés dans un matériau d'enrobage isolant 50 qui adhère fortement aux métallisations 40 à la pastille 42 et aux fils 48. Il s'agit par exemple d'une résine thermodurcissable . De plus le matériau d'enrobage 50 est moulé ou usiné pour présenter un fond 52 sensiblement plat et parallèle au support isolant 32. La paroi latérale 54 du matériau d'enrobage est inclinée est fait un angle a inférieur à 90° avec la portion non recouverte par le matériau d'enrobage de la face 32b du support isolant 32.

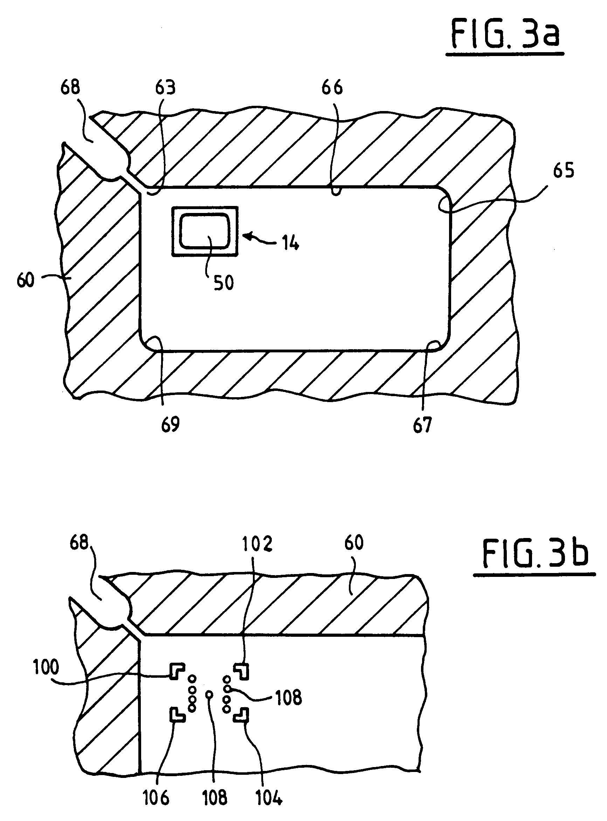

En se référant maintenant à la figure 3 on va décrire un premier mode, selon l'invention, de réalisation du corps de carte et de fixation du module électronique dans le corps de carte. Le moule est constitué essentiellement par une partie avant fixe 60 et par une partie arrière amovible 62, ces deux parties définissant l'empreinte pour réaliser le corps de la carte. Plus précisément la partie 60 comporte une première paroi plane 64 qui définit une des faces principales du corps de carte et une paroi latérale 66 qui définit la tranche du corps de carte. La deuxième partie 62 du moule définit la deuxième face principale du corps de carte. La paroi latérale 66 de la partie avant 60 du moule est munie d'un canal d'injection 68 pour faire pénétrer à l'intérieur du moule le matériau plastique servant à réaliser le corps de carte. La paroi 64 est munie de moyens pour maintenir immobile le module électronique 14 lors de l'injection du matériau plastique dans le moule. Selon ce premier mode de mise en oeuvre de l'invention, ces moyens comprennent des picots tels que 70 faisant saillie hors de la face interne 64 du moule, et un système de mis en dépression comportant un ajutage d'aspiration 72 associé à une pompe à vide 74. Les picots 70 présentent la même disposition spatiale que les trous 36 ménagés dans le module électronique 14. De plus l'ajutage d'aspiration 72 débouche dans la partie de la paroi 64 limitée par les picots 70.

La fabrication d'une carte selon le premier mode de mise en oeuvre de l'invention est réalisée de la manière suivante : le moule étant ouvert, le module électronique est mis en place de telle manière que les picots 70 pénêtrent dans les trous 36 des métallisations 16 à 30 du module. La pompe à vide 74 est mise en route. Le module 14 est donc maintenu contre la paroi 64 du moule dans les trois directions et positionné par la coopération des picots 70 et des trous 36. La partie arrière 62 du moule est plaquée sur la partie avant 60. On commande alors l'injection du matériau plastique par le canal d'injection 68. Le matériau plastique remplit l'ensemble de la cavité limitée par le moule et non occupée par le module électronique 14. On procède ensuite au démoulage de la carte.

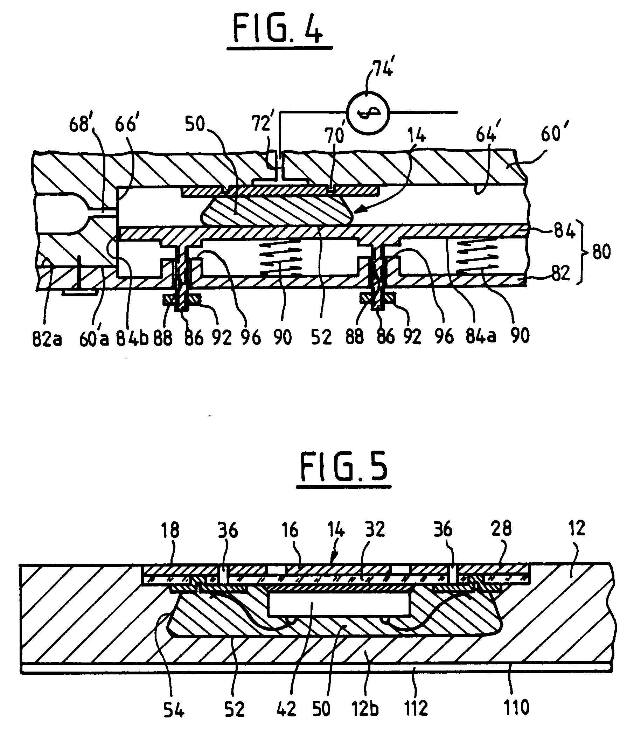

La figure 5 montre une vue partielle en coupe verticale d'une carte obtenue par la mise en oeuvre du procédé qui vent d'être décrit. Il faut souligner tout d'abord que, en raison de la forme particulière de l'enrobage 50 et de la réalisation du corps de carte par surmoulage du module électronique , le module électronique est mécaniquement ancré dans le corps de carte. On obtient ainsi une très bonne fixation du module dans le corps de carte 12. En outre, comme la face externe du module électronique est plaquée contre la paroi 64 du moule, il n'y a pas de dépôt de matériau plastique sur les plages de contact électrique 16 à 30. De plus, comme c'est la périphérie 76 du support isolant 32 et des plages de contact 16 à 30 qui limite le remplissage de la cavité du moule par le matériau plastique, l'aspect extérieur de la carte, dans la zone de liaison entre la face externe du module électronique et la face correspondante du corps de carte, est particulièrement satisfaisant.

De préférence, comme le montre la figure 3a, le canal d'injection 68 débouche dans un "coin" 63 du moule définissant un coin du corps de carte qui forme un angle droit alors que les autres "coins" références 65 67 et 69 sont arrondis. Ainsi, après découpage du coin 63 du corps de carte toute trace éventuelle d'injection disparait. Il est possible de prévoir plusieurs canaux d'injection débouchant chacun dans un "coin" du moule.

La figure 3b montre une variante de réalisation des moyens de positionnement et de maintien du module électronique dans le moule. Au lieu ou en plus des picots 70, la paroi 64 du moule comprend quatre portions en saillie référencées 100 à 106 qui correspondent aux quatre coins du support isolant du module électronique. L'ajutage d'aspiration 72 débouche dans la portion de la paroi 64 limitée par les éléments en saillie 100 à 106. Comme le montre la figure 3b l'ajutage d'aspiration peut se terminer par une pluralité d'orifices 108 correspondant chacun à une plage de contact du module électronique. Au lieu des quatre portions 100 à 106 on pourrait avoir un cadre rectangulaire complet faisant saillie dans la face 64 du moule.

Il va de soi qu'on pourrait utiliser d'autres types de module électronique. Par exemple des modules électroniques du type décrit dans les demandes de brevet français 2.547.440, 2.555.780 ou 2.579.799. Il peut encore s'agir d'un module électronique du type à "lead-frame". De tels modules électroniques sont décrits dans la demande de brevet européen Nr 87/401697 déposée le 21 juillet 1987. Un tel module ne comporte pas de support isolant. La pastille semi conductrice est directement fixée sur un élément conducteur formant une des plages de contact de la carte à mémoire et les bornes de la pastille sont reliées par des fils conducteurs à d'autres éléments conducteurs qui forment les autres plages de connexion de la carte.

Au lieu que le module électronique présente un élément d'ancrage tel que la forme externe particulière de l'enrobage du chip, il est possible que le module présente une partie d'accrochage avec le corps de carte lors de la réalisation de celui-ci par surmoulage. Par exemple, le module électronique peut être de type représenté sur la figure 2 mais sans le matériau d'enrobage 50. La partie d'accrochage du module électronique consiste alors dans toutes les aspérités du modules électronique, y compris les fils 48 d'interconnexion, qui apparaissent sur la face du module électronique ne comportant pas les plages de contact externes 16, 18. Il est également possible d'améliorer les propriétés d'accrochage du module électronique vis-à-vis du corps de carte, par exemple par un traitement de surface du support isolant 32 du module, lorsqu'il existe, dans ses parties non métallisées. Il est encore possible de prévoir des perçages de petites dimensions dans le support de module, que ce support soit en matériau isolant ou en matériau conducteur, pour améliorer l'accrochage par pénétration du matériau de moulage dans ces perçages. Il est encore possible de mettre en oeuvre un accrochage physico-chimique, ou de combiner ce type d'accrochage avec un accrochage mécanique, ou ancrage, du type décrit précédemment. L'accrochage physico-chimique peut résulter d'un choix judicieux du matériau de moulage et des matériaux dont sont faites les différentes parties du module électronique, notamment le support isolant. Il est également possible de mettre en oeuvre un traitement de surface chimique d'une partie du module électronique, par exemple le support isolant, pour favoriser l'accrochage physico-chimique lors de l'opération de moulage.

On voit que dans la présente demande de brevet, l'expression "partie d'accrochage" du module électronique ne désigne pas uniquement une forme particulière de l'enrobage du module permettant l'ancrage de celui-ci dans le corps de carte, mais toutes les dispositions ou combinaisons de dispositions décrites ci-dessus et qui visent à permettre la solidarisation du module électronique dans le corps de carte lors de la réalisation de celui-ci par moulage.

Dans la description précédente la carte ne comporte qu'un seul module électronique. On pourrait à l'aide du procédé de l'invention réaliser une carte ayant plusieurs modules indépendants. Dans ce cas le moule est muni d'autant de moyens de fixation (picots 70, Ajutage d'aspiration 72) qu'il y a de modules, les plages de contact électrique des modules pouvant indifféremment déboucher dans l'une ou l'autre des faces principales de la carte. La figure 4 montre un deuxième type de moule qui peut être utilisé pour la mise en oeuvre de procédé selon l'invention, et qui permet d'améliorer encore le maintien en place du module électronique lors du début de l'injection du matériau plastique dans le moule.

Le moule de la figure 4 comporte une partie avant fixe 60′ qui est identique à la partie avant 60 du moule de la figure 3. Pour cette raison, pour désigner les différents éléments de la partie avant 60′, on a repris les références de la figure 3 mais en les affectant du signe "prime". La partie arrière du moule 80 comprend un premier plateau 82 dont la périphérie 82a est destinée à être plaquée sur la face 60′a de la partie avant du moule 60′, et un deuxième plateau mobile 84. Le plateau 84 peut être déplacé par rapport au plateau 82 en étant assujetti à rester rigoureusement parallèle à la face 64′ de la partie avant 60′ du moule. Pour cela la face arrière 84a du plateau 84 est munie de tiges de guidage 86 qui peuvent coulisser avec un jeu très réduit dans des paliers 88 solidaires du plateau 82. Le plateau 84 a des dimensions telles que sa tranche 84b glisse le long de la paroi latérale 66′ de la partie avant 60′. Des ressorts tarés 90 provoquent l'écartement du plateau 84 par rapport au plateau 82, cet écartement étant limité par des butées 92 solidaires des tiges 86.

La fabrication de la carte à mémoire à l'aide du moule de la figure 4 est réalisée de la manière suivante. La partie arrière du moule 80 étant enlevée, le module électronique 14 est mis en place contre la paroi 64′ comme cela a déjà été décrit en liaison avec la figure 3. Puis la partie arrière 80 est fixée sur la partie avant 64′ du moule. Le plateau 84 vient en butée sur la face 52 de l'enrobage 50 du module électronique 14. Les ressorts 90 sont choisis de telle manière que, dans la position qui vient d'être décrite, ils soient déjà partiellement comprimés. La précontrainte des ressorts 90 améliore encore la façon dont le module électronique est maintenu plaqué contre la paroi 64′ du moule. Puis on commande l'introduction du matériau plastique dans le moule par le canal d'injection 68′. Dans une première phase, en raison de la précontrainte des ressorts 90 , le plateau 84 reste immobile en appui sur la surface 52 du module et le matériau plastique remplit l'espace entourant le module 14 et limité par le plateau 84 et la partie avant du moule 60′. Cette phase dure jusqu'à ce que la pression du matériau plastique compense la précontrainte des ressorts 90 Puis le matériau plastique repousse progressivement le plateau 84 en comprimant les ressorts 90, le plateau 84 n'étant plus en contact avec le module 14. Cependant le matériau plastique entoure alors complétement le module électronique 14 ce qui participe à son maintien en place contre la paroi 64′. Le plateau 84 est repoussé par le matériau plastique jusqu'à ce qu'il arrive en contact avec des butées mécaniques 96 solidaires du plateau 82. Cette position est déterminée pour que le corps de carte ainsi obtenu ait l'épaisseur requise compte tenu du retrait. L'injection est alors arrêtée, la partie arrière 82 enlevée et la carte extraite du moule. On obtient ainsi une carte identique à celle qui est représentée sur la figure 5. Il va de soi que le moule de la figure 4 peut comporter les variantes illustrées par les figures 3a et 3b.

Le matériau plastique qui est utilisé pour la réalisation du corps de carte par moulage peut être un acrylonitryl-butadiène-styrène ou tout autre type de matériau plastique similaire. Dans le cas de l'A.B.S., le matériau est injecté à une température comprise entre 180 C et 280 C et de préférence entre 220 et 260 C, et le moule est maintenu à une température comprise entre 5 et 100 C de préférence entre 10 et 50 C.

On peut également utiliser comme matériau thermoplastique le polystyrène, le polypropylène et le polyamine 11.

Comme le montre la figure 5 on peut fixer sur la face arrière 110 du corps de carte une piste magnétique 112 par exemple par pressage à chaud. Il faut souligner que le mode de réalisation du corps de carte selon l'invention se prête particuliairement bien à la mise en place de cette piste. En effet la portion 12b du corps de carte disposée entre le module électronique et la face arrière 110 du corps de carte présente une grande stabilité malgrè son épaisseur réduite du fait que cette portion est directement surmoulée sur la face 52 du module électronique. En outre le matériau utilisé se prête très bien à l'inscription par embossage d'informations sur une des faces principales du corps de carte.

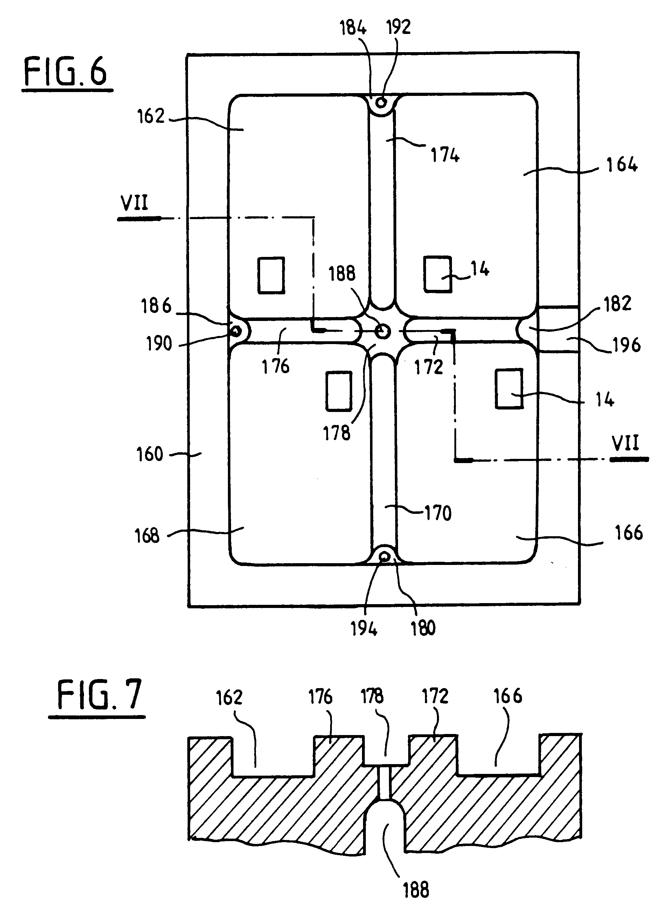

En se référant aux figures 6 et 7 on va décrire un mode de réalisation du moule qui permet d'obtenir simultanément plusieurs cartes.

Sur la figure 6 on a représenté la partie avant 160 du moule qui comporte l'ensemble des empreintes. La partie 160 du moule comporte 4 empreintes 162, 164, 166 et 168 qui définissent les corps des quatre cartes fabriquées simultanément. Dans chaque empreinte 162 à 168 est mis en place un module électronique 14 selon une des techniques décrites en liaison avec les figures 3 à 3b. Les empreintes 162 à 168 sont séparées les unes des autres par des parties en saillie 170 à 176. Comme le montre la figure 6, les parties en saillie 170 à 176 ne séparent pas totalement les empreintes les unes des autres, mais des passages font communiquer les empreintes entre elles. On trouve un passage central 178 qui fait communiquer les quatres empreintes, et des passages d'extrémité 180 à 186 qui font communiquer les empreintes deux à deux à proximité de la périphérie de la partie avant 160 du moule. Comme le montre la figure 7, les passages 178 à 186 ont une profondeur inférieure à celle des empreintes 162 à 168. Il va de soi que ces passages pourraient avoir la même profondeur que les empreintes. L'injection de la matière dans le moule peut se faire de deux manières : soit on effectue l'injection en plusieurs points 188 à 194, chaque point d'injection débouchant dans un des passages 178 à 186 ; soit on effectue l'injection en nappe par l'ouverture latérale 196 qui débouche dans le passage 182.

Après démoulage on obtient une pièce unique qui consiste en quatre cartes, correspondant aux empreintes 162 à 168, reliées entre elles par des "points" correspondant au matériau plastique qui a rempli les passages 178 à 186.

Le fait d'obtenir quatre cartes reliées mécaniquement entre elles avec des positionnements relatifs très précis des cartes, est très avantageux pour effectuer ultérieurement l'impression par offset du corps de carte. En effet, d'une part l'impression peut se faire simultanément, d'autre part la pièce ayant des dimensions plus importantes il est plus facile de la positionner sur la machine d'impression.

Pour séparer les cartes les unes des autres, il suffit de découper les "points". Cette opération ne présente aucune difficulté particulière puisque les "points" sont attachés aux corps de carte à un de leurs "coins", il s'agit donc d'une partie non fonctionnelle du corps de carte. En outre, les points d'injection 188 à 196 débouchant dans ces "points", les traces d'injection sont éliminées en même temps que les "points".

## Revendications

1. Procédé de réalisation d'une carte à mémoire électronique comprenant un module mémoire électronique (14) comportant des plages de contact externes (16 à 30), une pastille semi-conductrice (42) solidaire de la face postérieure desdits contacts, des moyens d'interconnexion (48) des bornes (46) de ladite pastille aux plages de contact et un matériau d'enrobage (50) de ladite pastille et un corps de carte (12), caractérisé en ce qu'il comprend les étapes suivantes :

on fournit un module mémoire électronique (14) comportant en outre une partie d'accrochage (50) destinée à la fixation dudit module dans le corps de carte (12) par un engagement positif de forme et/ou par accrochage physico-chimique ;

on place ledit module mémoire électronique (14) dans un moule d'injection (60, 62, 62', 80) dont la cavité interne définit la forme du corps de carte et on maintient le module électronique de telle manière que les plages de contact externe (16 à 30) soient plaquées contre une paroi (64, 64') de ladite cavité à l'aide de moyens (70, 72, 100 à 108) solidaires dudit moule ;

on injecte à chaud et sous pression dans la cavité dudit moule un matériau thermo-plastique choisi dans le groupe comprenant l'acrylonitryl-butadiène-styrène, le polystyrène, le propylène et le polyamine 11, de telle manière que ledit matériau plastique remplisse la totalité de la cavité non occupée par ledit module, et

on démoule la pièce ainsi réalisée.

2. Procédé selon la revendication 1, caractérisé en ce que ladite partie d'accrochage consiste en une forme particulière dudit matériau d'enrobage (50).

3. Procédé selon la revendication 1, dans lequel le corps (12) de la carte présente deux faces principales, lesdites plages de contact électrique (16 à 30) affleurant dans une desdistes faces principales, caractérisé en ce qu'on place ledit module mémoire électronique (14) dans le moule pour que lesdites plages externes de contact soient disposées contre la paroi (64) du moule définissant une des faces principales du corps de carte (12) et en ce qu'on crée une dépression (70) entre ladite paroi du moule (64) et lesdites plages de contact externes pour maintenir ledit module contre ladite paroi.

4. Procédé selon la revendication 2, caractérisé en ce que lesdites plages de contact (16 à 30) sont munies d'une pluralité de trous (36) pour coopérer avec des picots (70) faisant saillie hors de la paroi du moule (64) contre laquelle est maintenu ledit module électronique.

5. Procédé selon la revendication 2, dans lequel le module électronique présente une face d'accès comportant les plages externe sensiblement rectangulaires, caractérisé en ce que la paroi (64) du moule sur laquelle est placé ledit module comporte une portion en saillie (100 à 106) entourant au moins partiellement ladite face d'accès dudit module.

6. Procédé selon la revendication 1, dans lequel le corps de carte comporte deux faces principales sensiblement rectangulaires, caractérisé en ce que l'injection (68) du matériau plastique est réalisée dans une partie du moule (62, 64) définissant un "coin" du corps de carte (12).

7. Procédé selon la revendication 1, caractérisé en ce qui, après le démoulage de ladite pièce, on fixe sur une des faces principales (110) du corps de carte une piste magnétique (112).

8. Procédé selon la revendication 1, caractérisé en ce que, après le démoulage de ladite pièce, on inscrit des mentions sur une des faces principales du corps de carte par embossage du matériau plastique.

9. Procédé selon la revendication 1, caractérisé en ce que ledit matériau plastique est choisi dans le groupe comprenant :

l'acrylonitryl-butadiène-styrène, le polystyrène, le polypropylène et le polyamine 11.

10. Procédé de réalisation d'une pluralité de cartes à mémoire électronique selon la revendication 1, caractérisé en ce que le moule (160) comporte une pluralité d'empreintes (162 à 168), chaque empreinte correspondant à la forme à donner à un corps de carte, et des passages (170 à 176) pour relier entre elles lesdites empreintes ; en ce qu'on place un module mémoire électronique (14) dans chaque empreinte du moule et on les maintient en place de telle manière que la face d'accès du module électronique (14) soit plaquée contre une paroi dudit moule ; on introduit dans ledit moule (160) le matériau thermo-plastique de telle manière que le matériau plastique occupe la totalité de l'espace correspondant à la partie desdites empreintes non occupée par lesdits modules mémoire électronique et auxdits passages ;

et on démoule la pièce ainsi réalisée.

11. Procédé selon la revendication 10, caractérisé en ce que ledit matériau thermo-plastique est introduit dans ledit moule (160) au droit (188) d'au moins certains desdits passages (170 à 176).

12. Procédé selon l'une quelconque des revendications 10 et 11, caractérisé en ce que le matériau thermo-plastique est choisi dans le groupe comprenant l'acrylonitryl-butadiène-styrène, le polystyrène, le polypropylène et le polyamide 11.

**Patentansprüche**

1. Verfahren zur Herstellung einer elektronischen Speicherkarte mit einem elektronischen Speichermodul (14), das externe Kontaktbereiche (16-30), einen Halbleiterchip (42), der mit der hinteren Seite der Kontakte verbunden ist, Verbindungseinrichtungen (48) von Anschlußklemmen (46) des Halbleiterchips mit den Kontaktbereichen und ein Umschließungsmaterial (50) des Chips und einen Kartenkörper (12) aufweist, dadurch gekennzeichnet, daß es die folgenden Schritte aufweist:

es wird ein elektronisches Speichermodul (14) geliefert, das weiterhin einen Anhängbereich (50) aufweist, der für die Befestigung des Moduls in dem Kartenkörper (12) bestimmt ist, durch positives Formeingreifen und/oder durch physikalisch-chemisches Anhängen;

Plazieren des elektronischen Speichermoduls (14) in eine Einspritzform (60,62,62',80), deren innerer Hohlraum die Form des Körpers definiert, und Beibehalten des elektronischen Moduls derart, daß die externen Anschlußbreiche (16-30) gegen eine Seitenwand (64,64') des Hohlraums mit Hilfe von Einrichtungen (70,72,100-108) plattiert oder bündig angelegt werden, die mit der Form verbunden sind;

Heiß- und unter-Druck-Einspritzen in den Hohlraum der Form eines thermoplastischen Materials, gewählt aus der Gruppe mit Acrylnitril-Butadien-Styrol, dem Polystyrol, dem Propylen und dem Polyamin 11 gewählt wird, derart, daß das Kunststoffmaterial die Gesamtheit des Hohlraums, der nicht von der Form besetzt wird, füllt, und

daß das so ausgebildete Teil ausgeformt wird.

2. Verfahren nach Anspruch 1, dadurch gekennzeichnet, daß der Anhängbereich aus einer besonderen Form des Umhüllungsmaterials (50) besteht.

3. Verfahren nach Anspruch 1, bei dem der Körper (12) der Karte zwei Hauptseiten aufweist, wobei die elektrischen Kontaktbereiche (16-30) in einer der Hauptseiten bündig eingelassen sind oder satt anliegen, dadurch gekennzeichnet, daß das elektronische Speichermodul (14) in die Form gesetzt wird, damit die äußeren Kontaktbereiche gegen die Seitenwand (64) der Form, die eine der Hauptseiten des Kartenkörpers (12) definiert, angeordnet sind und daß ein Unterdruck (70) zwischen der Seitenwand der Form (64) und den äußeren Kontaktbereichen erzeugt wird, um das Modul gegen die Seitenwand zu halten.

4. Verfahren nach Anspruch 2, dadurch gekennzeichnet, daß die Kontaktbereiche (16-30) mit einer Mehrzahl von Löchern (36) versehen sind, um mit Stacheln (70) zusammenzuwirken, die über die Seitenwand der Form (64) vorspringen, gegen die das elektronische Modul gehalten wird.

5. Verfahren nach Anspruch 2, bei dem das elektronische Modul eine Zugangsseite aufweist, die die im wesentlichen rechtwinkligen Außenanschlüsse aufweist, dadurch gekennzeichnet, daß die Seitenwand (64) der Form, auf der das Modul plaziert ist, einen Vorsprungbereich (100-106) aufweist, der wenigstens teilweise die Zugangsseite des Moduls umgibt.

6. Verfahren nach Anspruch 1, bei dem der Kartenkörper wenigstens zwei Hauptseiten aufweist, die im wesentlichen rechtwinklig sind, dadurch gekennzeichnet, daß das Einspritzen (68) des Kunststoffmaterials in einem Bereich der Form (62,64) erzeugt wird, der wenigstens eine "Ecke" des Kartenkörpers (12) definiert.

7. Verfahren nach Anspruch 1, dadurch gekennzeichnet, daß nach Ausformen des genannten Teils auf einer der Hauptseiten (110) des Kartenkörpers eine Magnetbahn (112) befestigt wird.

8. Verfahren nach Anspruch 1, dadurch gekennzeichnet, daß nach Ausformen des genannten Teils Bemerkungen auf einer der Hauptseiten des Kartenkörpers durch Einprägen des Kunststoffmaterials eingeschrieben werden.

9. Verfahren nach Anspruch 1, dadurch gekennzeichnet, daß das Kunststoffmaterial ausgewählt wird aus der Gruppe mit:

Acrylnitril-Butandien-Styrol, dem Polystyrol, dem Polypropylen und dem Polyamin 11.

10. Verfahren zur Herstellung einer Mehrzahl von elektronischen Speicherkarten nach Anspruch 1, dadurch gekennzeichnet, daß die Form (160) eine Mehrzahl von Einprägungen (162-168) aufweist, wobei jede Einprägung der Form entspricht, die einem Kartenkörper zu verleihen ist, und Kanäle (170-176) aufweist, um zwischen ihnen die Einprägungen zu verbinden; daß ein elektronisches Speichermodul (14) in jede Einprägung der Form gesetzt und diese vor Ort derart gehalten wurd, daß die Zugangsseite des elektronsichen Moduls (14) gegen eine Seitenwand der Form bündig anliegt; wobei in die Form (160) das thermoplastische Material eingeführt wird, derart, daß das Kunststoffmaterial den gesamten Raum einnimmt, der den nicht durch die elektronischen Speichermodule besetzten Einprägungen und den Leitungen entspricht; und daß das so hergestellte Teil ausgeformt wird.

11. Verfahren nach Anspruch 10, dadurch gekennzeichnet, daß das thermoplastische Material in die Form (160) im rechten Winkel (188) zu wenigstens einigen der genannten Leitungen (170-176) eingeführt wird.

12. Verfahren nach einem der Ansprüche 10 oder 11, dadurch gekennzeichnet, daß das thermoplastische Material ausgewählt wird aus der Gruppe mit Acrylnitril-Butadien-Styrol, dem Polystyrol, dem Polypropylen und dem Polyamid 11.

## Claims

1. Process for the manufacture of an electronic memory card comprising an electronic storage module (14) having external contact tabs (16 to 30), a semi-conducting chip (42) fixed to the rear faces of the said contacts, means (48) for interconnection of the terminals (46) of the said chip and the contact tabs and a coating material (50) for the said chip and a card body (12), characterised in that it comprises the following steps:

– an electronic storage module (14) is provided moreover comprising a fastening portion (50) adapted to fix the said module in the card body (12) by positive engagement and/or by physico-chemical fastening;

– the said electronic storage module (14) is placed in an injection mould (60, 62, 62', 80), the inner cavity of which defines the shape of the card body and the electronic module is held in such a manner that the external contact tabs (16 to 30) are pressed against a wall (64, 64') of the said cavity with the aid of means (70, 72, 100 to 108) fixed to the said mould;

– a thermoplastic material selected from the group comprising acrylonitrile-butadiene-styrene, polystyrene, propylene and polyamine 11, is injected under heat and under pressure into the cavity of the said mould in such a manner that the said plastic material fills the entirety of the cavity not occupied by the said module, and

– the component manufactured in this manner is removed from the mould.

2. Process according to claim 1, characterised in that the said fastening portion consists of a particular shape of the said coating material (50).

3. Process according to claim 1, in which the body (12) of the card has two main faces, the said electrical contact tabs (16 to 30) being flush with one of the said main faces, characterised in that the said electronic storage module (14) is placed in the mould so that the said external contact tabs are disposed against the wall (64) of the mould defining one of the main faces of the card body (12) and that a depression (70) is created between the said wall of the mould (64) and the said external contact tabs in order to hold the said module against the said wall.

4. Process according to claim 2, characterised in that the said contact tabs (16 to 30) are provided with a plurality of holes (36) for cooperation with pins (70) projecting beyond the wall of the mould (64) against which the said electronic module is held.

5. Process according to claim 2, in which the electronic module has an access face comprising the substantially rectangular external tabs, characterised in that the wall (64) of the mould on which the said module is placed comprises a projecting portion (100 to 106) at least partially surrounding the said access face of the said module.

6. Process according to claim 1, in which the card body comprises two substantially rectangular main faces, characterised in that the plastic material is injected (68) in a part of the mould (62, 64) defining a "corner" of the card body (12).

7. Process according to claim 1, characterised in that after the said component has been removed from the mould, a magnetic track (112) is fixed to one of the main faces (110) of the card body.

8. Process according to claim 1, characterised in that after the said component has been removed from the mould, data is marked on one of the main faces of the card body by embossing the plastic material.

9. Process according to claim 1, characterised in that the said plastic material is selected from the group comprising acrylonitrile-butadiene-styrene, polystyrene, polypropylene and polyamine 11.

10. Process for the manufacture of a plurality of electronic memory cards according to claim 1, characterised in that the mould (160) comprises a plurality of cavities (162 to 168), each cavity corresponding to the shape to be given to a card body, and passages (170 to 176) for connecting the said cavities to one another, and that an electronic storage module (14) is placed in each cavity of the mould and these are held in position in such a manner that the access face of the electronic module (14) is pressed against a wall of the said mould, that the thermoplastic material is introduced into the said mould (160) in such a manner that the plastic material occupies all of the space corresponding to the part of the said cavities not occupied by the said electronic storage modules and to the said passages, and that the component manufactured in this manner is removed from the mould.

11. Process according to claim 10, characterised in that the said thermoplastic material is introduced into the said mould (160) at right angles (188) to at least some of the said passages (170 to 176).

12. Process according to either of claims 10 and 11, characterised in that the thermoplastic material is selected from the group comprising acrylonitrile-butadienestyrene, polystyrene, polypropylene and polyamine 11.

FIG.1

FIG.2

FIG.3

## FIG. 3a

68    63    66

65

60

14

50

69    67

## FIG. 3b

68    102    60

100

108

106    108    104

# FIG. 4

# FIG. 5

## FIG.6

## FIG.7